# EUROPEAN PATENT APPLICATION

(11) **EP 3 037 475 A1**
(43) Date of publication of application: **29.06.2016**
(21) Application number: 14894791.4
(22) Date of filing: 13.06.2014
(51) Int. Cl.: C08L 63/00, C08G 63/692, H01B 3/40, H05K 1/03

(54) **PHENOXY CYCLOTRIPHOSPHAZENE ACTIVE ESTER, HALOGEN-FREE RESIN COMPOSITION AND USE THEREOF**

(71) Applicant: Shengyi Technology Co., Ltd., Dongguan City, Guangdong 523808 (CN)
(72) Inventor: HE, Yueshan, Dongguan City Guangdong 523808 (CN)
(74) Representative: Wallinger, Michael
(86) International application number: PCT/CN2014/079854
(87) International publication number: WO 2015/188377

(57) **Abstract**

The present invention discloses a phenoxycyclotriphosphazene active ester, a halogen-free resin composition and uses thereof. The phenoxycyclotriphosphazene active ester comprises at least 65 mol.% of a substance having the following structural formula. The halogen-free resin composition comprises 5-50 parts by weight of a phenoxycyclotriphosphazene active ester, 15-85 parts by weight of a thermosetting resin, 1-35 parts by weight of a curing agent, 0-5 parts by weight of a curing accelerator and 0-100 parts by weight of an inorganic filler. The present invention discloses introducing phenoxycyclotriphosphazene active ester into a thermosetting resin, reacting active esters with thermosetting resins, such as epoxy resin, without producing hydroxy groups, which not only satisfies the requirements on being halogen-free and flame retardancy, but also improves the electrical properties (decreasing and stabilizing Dk and Df) of the system, so as to make non-halogenation of high frequency and high speed substrate materials possible.

## Description

### Technical field

The present invention relates to a phenoxycyclotriphosphazene active ester, a halogen-free resin composition and uses thereof, wherein said halogen-free resin composition is used for preparing prepregs, laminates and printed wiring boards.

### Background art

In recent years, electronic equipments, especially those using broadband, e.g. mobile communication devices, have been continuously improved with the development of integrated technology, bonding technology and assembly technology of semiconductor devices used in electronic equipments, high-density electronic device components and the wiring of high-density printed wiring boards.

Printed wiring boards, as a component of such electronic devices, are developed in the direction of higher-integration printed wiring boards and more precise wiring. In order to increase the signal transmission rate to a level required for speeding up information processing, the effective method is to decrease the dielectric constant of the materials used therein; in order to decrease the transmission loss, the effective method is to use materials having a lower dielectric loss tangent (dielectric loss).

With the rapid development of electronic technique, environmental protection is more and more pursued. The conventional high-frequency and high-speed materials primarily achieve the object of flame retardancy by using halides and antimonides. While igniting and combusting, copper clad laminates containing halides not only produce a large amount of smoke and unpleasant odor, but also give off halogen hydride gas having a high toxicity and a strong corrosivity, which pollutes the environment and does harm to human health. Currently, epoxy resins corresponding to phosphorous-containing phenanthrene compounds DOPO or ODOPB are industrially used to make common FR-4 achieve flame retardancy. However, phosphorous-containing phenanthrene compounds DOPO or ODOPB still have a high water absorption rate, which has an extremely great effect on the dielectric constant and dielectric loss angle tangent of high-frequency and high-speed materials.

### Disclosure of the invention

As for the existing technical problems, one object of the present invention lies in providing a phenoxycyclotriphosphazene active ester, introducing it into a thermosetting resin, reacting its reactive groups with specific thermosetting resin without producing hydroxyl groups, which not only can satisfy the requirements on being halogen-free and flame retardancy, but also can make a few changes to dielectric constant and dielectric loss angle tangent, so as to improve the electrical properties and make being halogen-free of high-frequency and high speed substrate materials possible.

In order to achieve the aforesaid object, the present invention uses the following technical solution,
a phenoxycyclotriphosphazene active ester, characterized in comprising at least 65 mol.% of a substance having the following structural formula 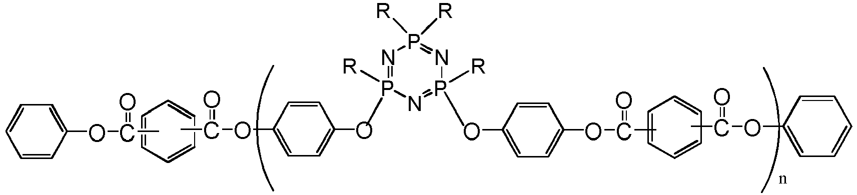 wherein, 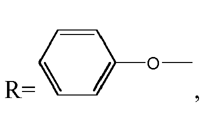 n represents any number between 0.25 and 3.

Said at least 65% is selected from the group consisting of, e.g. 66%, 67%, 68%, 69%, 70%, 71%, 72%, 73%, 74%, 75%, 76%, 77%, 78%, 79%, 80%, 81%, 82%, 83%, 84%, 85%, 86%, 87%, 88%, 89%, 90%, 91%, 92%, 93%, 94%, 95%, 96%, 97%, 98% or 99%.

n is selected from the group consisting of, e.g. 0.28, 0.35, 0.42, 0.5, 0.6, 0.7, 0.8, 0.9, 1, 1.1, 1.2, 1.3, 1.4, 1.5, 1.6, 1.7, 1.8, 1.9, 2, 2.1, 2.2, 2.3, 2.4, 2.5, 2.6, 2.7, 2.8 or 2.9.

The exemplary method for preparing phenoxycyclotriphosphazene active ester is stated as follows.

A solvent, a phenoxycyclotriphosphazene containing hydroxyl groups (wherein those containing two hydroxyl groups are in a proportion of higher than 65%), an acid-binding agent and a catalyst were added into a reaction device, stirred, protected by introducing nitrogen, and gradually dripped at a temperature of less than 20°C with a certain amount of p-benzoyl chloride. After reacting for 1-8 hours, an excess of phenol was added, further reacted for 1-8 hours, cooled to room temperature, and filtered by suction. The filtrate was pressure-distilled to evaporate the solvent to obtain a viscous product, i.e. phenoxycyclotriphosphazene active ester.

The phenoxycyclotriphosphazene active ester prepared by such method is a mixture, and inevitably contains other components, e.g. impurities, wherein there contains at least 65% of the substance having the aforesaid structural formula.

The second object of the present invention lies in providing a halogen-free resin composition, comprising 5-50 parts by weight of a phenoxycyclotriphosphazene active ester, 15-85 parts by weight of a thermosetting resin, 1-35 parts by weight of a curing agent, 0-5 parts by weight of a curing accelerator and 0-100 parts by weight of an inorganic filler,
wherein the thermosetting resin is selected from the group consisting of epoxy resin, benzoxazine resin, cyanate resin, bismaleimide resin, reactive polyphenyl ether resin or hydrocarbon resin, or a mixture of at least two selected therefrom.

The reactive polyphenyl ether resin is a polyphenyl ether resin in which crosslinking reactive groups are introduced into the main chain thereof.

Said phenoxycyclotriphosphazene active ester is in an amount of, e.g. 7, 9, 11, 13, 15, 17, 19, 21, 23, 25, 27, 29, 31, 35, 37, 39, 41, 43, 45, 47 or 49 parts by weight.

Said thermosetting resin is in an amount of, e.g. 18, 21, 24, 27, 30, 33, 36, 39, 42, 45, 48, 51, 54, 57, 60, 63, 66, 69, 72, 75, 78, 81 or 84 parts by weight.

Said curing agent is in an amount of, e.g. 2, 4, 6, 8, 10, 12, 14, 16, 18, 20, 22, 24, 26, 28, 30, 32 or 34 parts by weight.

Said curing accelerator is in an amount of, e.g. 0.2, 0.5, 0.8, 1.1, 1.4, 1.7, 2, 2.3, 2.6, 2.9, 3.2, 3.5, 3.8, 4.1, 4.4, 4.6 or 4.8 parts by weight.

Said inorganic filer is in an amount of, e.g. 4, 8, 12, 16, 20, 24, 28, 32, 36, 40, 44, 48, 52, 56, 60, 64, 68, 72, 76, 80, 84, 88, 92, 96 or 98 parts by weight, preferably 25-100 parts by weight.

The present invention discloses introducing a phenoxycyclotriphosphazene active ester into a thermosetting resin, reacting the active esters with epoxy resin without producing hydroxyl groups, which not only can satisfy the requirements on being halogen-free and flame retardancy, but also can improve the electrical properties of the system (decreasing and stabilizing Dk and Df), so as to make being halogen-free of high-frequency and high speed substrate materials possible.

Preferably, the thermosetting resin comprises dicyclopentadiene, biphenyl or naphthalene ring. Due to dicyclopentadiene, biphenyl or naphthalene ring group, the dielectric properties thereof are superior to the thermosetting resins having other structures.

Preferably, the epoxy resin is anyone selected from the group consisting of bisphenol A epoxy resin, bisphenol F epoxy resin, DCPD epoxy resin, triphenol epoxy resin, biphenyl epoxy resin or naphthol epoxy resin, or a mixture of at least two selected therefrom. The mixture is selected from the group consisting of, e.g. a mixture of bisphenol A epoxy resin and bisphenol F epoxy resin, a mixture of DCPD epoxy resin and triphenol epoxy resin, a mixture of biphenyl epoxy resin and naphthol epoxy resin, a mixture of bisphenol A epoxy resin, bisphenol F epoxy resin and DCPD epoxy resin, and a mixture of triphenol epoxy resin, biphenyl epoxy resin and naphthol epoxy resin.

Preferably, the epoxy resin is a phosphorous-containing epoxy resin containing phosphorous in an amount of 1.5-6.0 wt.% (e.g. 1.8 wt.%, 2.1 wt.%, 2.4 wt.%, 2.7 wt.%, 3 wt.%, 3.3 wt.%, 3.6 wt.%, 3.9 wt.%, 4.2 wt.%, 4.5 wt.%, 4.8 wt.%, 5.1 wt.%, 5.4 wt.% or 5.7 wt.%).

Preferably, the benzoxazine resin is anyone selected from the group consisting of bisphenol A benzoxazine resin, bisphenol F benzoxazine resin, DCPD benzoxazine resin or phenothalin benzoxazine resin, or a mixture of at least two selected therefrom. The mixture is selected from the group consisting of, e.g. a mixture of bisphenol A benzoxazine resin and bisphenol F benzoxazine resin, a mixture of DCPD benzoxazine resin and phenothalin benzoxazine resin, a mixture of bisphenol A benzoxazine resin, bisphenol F benzoxazine resin and DCPD benzoxazine resin, a mixture of phenothalin benzoxazine resin, bisphenol A benzoxazine resin, bisphenol F benzoxazine resin, DCPD benzoxazine resin and phenothalin benzoxazine resin.

Preferably, the cyanate resin is anyone selected from the group consisting of bisphenol A cyanate resin, DCPD cyanate resin and phenolic aldehyde cyanate resin, or a mixture of at least two selected therefrom. The mixture is selected from the group consisting of, e.g. a mixture of bisphenol A cyanate resin and DCPD cyanate resin, a mixture of phenolic aldehyde cyanate resin and bisphenol A cyanate resin, a mixture of DCPD cyanate resin and phenolic aldehyde cyanate resin, and a mixture of bisphenol A cyanate resin, DCPD cyanate resin and phenolic aldehyde cyanate resin.

Preferably, the bismaleimide resin comprises 4,4'-diphenylmethane bismaleimide or/and allyl-modified diphenylmethane bismaleimide.

Preferably, the reactive polyphenyl ether resin has a number average molecular weight of 1000-7000, and has the reactive groups of hydroxyl groups or/and double bonds.

Preferably, the hydrocarbon resin is anyone selected from the group consisting of vinyl styrene butadiene resin having a number average molecular weight of less than 11,000, vinyl polybutadiene resin having polar groups and maleic anhydride-grafted butadiene and styrene resin, or a copolymer of at least two selected therefrom.

Preferably, the curing agent is anyone selected from the group consisting of dicyandiamide, aromatic amine, anhydride, phenolic compounds, triene isocyanurate and phosphorous-containing phenolic aldehyde, or a mixture of at least two selected therefrom. The mixture is selected from the group consisting of, e.g. a mixture of dicyandiamide and aromatic amine, a mixture of anhydride and phenolic compounds, a mixture of triene isocyanurate and phosphorous-containing phenolic aldehyde, a mixture of dicyandiamide, aromatic amine and anhydride, and a mixture of phenolic compounds, triene isocyanurate and phosphorous-containing phenolic aldehyde.

Preferably, the curing accelerator is anyone selected from the group consisting of 2-methylimidazole, 2-ethyl-4-methylimidazole, 2-phenylimidazole, pyridine, DMP-30, hexamethylenetetramine, dicumyl peroxide, t-butyl peroxybenzoate, 2,5-di(2-ethyl-hexanoylperoxy)-2,5-dimethylhexane, acetylacetonate and zincate, or a mixture of at least two selected therefrom. The mixture is selected from the group consisting of, e.g. a mixture of 2-methylimidazole and 2-ethyl-4-methylimidazole, a mixture of 2-phenylimidazole and pyridine, a mixture of DMP-30 and hexamethylenetetramine, a mixture of dicumyl peroxide and t-butyl peroxybenzoate, a mixture of 2,5-di(2-ethylhexanoylperoxy)-2,5-dimethylhexane, acetylacetonate and zincate, a mixture of 2-methylimidazole, 2-ethyl-4-methylimidazole and 2-phenylimidazole, a mixture of pyridine, DMP-30 and hexamethylenetetramine, and a mixture of dicumyl peroxide, t-butyl peroxybenzoate, 2,5-di(2-ethylhexanoylperoxy)-2,5-dimethylhexane, acetylacetonate and zincate.

Preferably, the inorganic filler is anyone selected from the group consisting of aluminium hydroxide, magnesium hydroxide, zeolite, wollastonite, silica, magnesium oxide, calcium silicate, calcium carbonate, clay, talc or mica, or a mixture of at least two selected therefrom. The mixture is selected from the group consisting of, e.g. a mixture of aluminium hydroxide and magnesium hydroxide, a mixture of zeolite and wollastonite, a mixture of silica and magnesium oxide, a mixture of calcium silicate and calcium carbonate, a mixture of clay, talc and mica, a mixture of aluminium hydroxide, magnesium hydroxide and zeolite, a mixture of wollastonite, silica, magnesium oxide and calcium silicate, and a mixture of calcium carbonate, clay, talc and mica.

The wording "comprise(s)/comprising" in the present invention means that, besides said components, there may be other components which endow the halogen-free resin composition with different properties. In addition, the wording "comprise(s)/comprising" in the present invention may be replaced with "is/are" or "consist of" in a closed manner.

Said halogen-free resin composition may contain various additives, e.g. antioxidants, heat stabilizers, antistatic agents, ultraviolet absorbers, pigments, colorants or lubricants, which may be used alone or in combination.

The third object of the present invention is to provide a prepreg comprising a reinforcing material and the aforesaid halogen-free resin composition attached thereon after impregnation and drying.

The fourth object of the present invention is to provide a laminate, comprising at least one prepreg as stated above.

The fifth object of the present invention is to provide a printed wiring board, comprising at least one prepreg as stated above.

The exemplary method for preparing the laminate comprises the following steps:
(1) dissolving a formula amount of the phenoxycyclotriphosphazene active ester in a solvent such as benzene or ketone etc., completely dissolving at room temperature or medium temperature;
(2) adding a formula amount of a thermosetting resin, a curing agent, optionally a curing accelerator and optionally an inorganic filler into the solution in step (1), homogeneously stirring to obtain a varnish, choosing a reinforcing material having a smooth surface, homogeneously coating the aforesaid varnish, and then baking to obtain a prepreg; and
(3) cutting the prepreg into a suitable size according to the size of the pressing machine, overlaying in order, placing one sheet of copper foil on each side thereof, pressing in a vacuum thermocompressor to obtain a copper clad laminate;

The baking temperature in step (2) was set generally between 85°C and 175°C according to the boiling point of the solvent used for the varnish, and the baking lasted commonly for 5-20 min.

In step (3), a multistep (heating and increasing the pressure step by step) procedure was used to press, wherein the temperature was increased by 15 min from room temperature to 150°C and maintained for 30 min, then increased by 5min to 180°C and maintained for 2 h, and finally decreased by 30 min to room temperature; the pressure was increased by 1min from 0 to 0.6Mpa and maintained for 20min, and then increased by 1min to 1.0Mpa and maintained for 2.5 h. The post-processing was carried at 200∼245°C and maintained for 1-5 hours.

As compared with the prior arts, the present invention has the following beneficial effects.

The present invention discloses introducing a phenoxycyclotriphosphazene active ester into a thermosetting resin, reacting the active esters with epoxy resin without producing hydroxyl groups, which not only can satisfy the requirements on being halogen-free and flame retardancy, but also can improve the electrical properties of the system (decreasing and stabilizing Dk and Df), so as to make being halogen-free of high-frequency and high speed substrate materials possible.

In the present invention, phenoxycyclotriphosphazene active ester is compounded with thermosetting resins such as epoxy resin, benzoxazine resin, cyanate resin, bismaleimide resin, micromolecular polyphenyl ether resin, hydrocarbon resin and the like, cured with a composite curing agent, mixed with some organic and inorganic filler, coated and laminated to obtain a copper clad plate. The resultant copper clad plate meets the requirements on being halogen-free, and has the advantages such as excellent heat resistance, humidity resistance and low dielectric loss.

### Embodiments

The technical solution of the present invention is further stated by the following embodiments.

### Example 1

A solvent, a phenoxycyclotriphosphazene containing hydroxyl groups (wherein those containing two hydroxyl groups are in a proportion of higher than 65%), an acid-binding agent and a catalyst were added into a reaction device, stirred, protected by introducing nitrogen, and gradually dripped at a low temperature with a certain amount of p-benzoyl chloride. After reacting for 1-8 hours, a suitable amount of phenol was added, further reacted for 1-8 hours, cooled to room temperature, and filtered by suction. The filtrate was pressure-distilled to evaporate the solvent to obtain a viscous product.

30 g of said product was dissolved in an organic solvent, and then 70 g of DCPD epoxy resin (which is HP-7200H (DIC), and has an equivalent of 275-280) and a suitable amount of imidazole and pyridine were added, homogeneously stirred and mixed to obtain a varnish.

E-glass fabric having a size of 300 × 300 cm and a smooth and flat surface was homogeneously covered with said varnish, baked in an oven having a temperature of 155°C for 7 min to obtain a bonding sheet.

5 sheets of bonding sheets above whose edges were removed were superimposed, attached up and down with copper foils having a thickness of 35µm, placed in a vacuum thermocompressor to press and obtain a copper clad laminate. A multistep (heating and increasing the pressure step by step) procedure was used to press, wherein the temperature was increased by 15 min from room temperature to 150°C and maintained for 30 min, then increased by 5min to 180°C and maintained for 2 h, and finally decreased by 30 min to room temperature; the pressure was increased by 1min from 0 to 0.6Mpa and maintained for 20min, and then increased by 1min to 1.0Mpa and maintained for 2.5 h. The basic performances are shown in Table 1.

### Example 2

A solvent, a phenoxycyclotriphosphazene containing hydroxyl groups (wherein those containing two hydroxyl groups are in a proportion of higher than 65%), an acid-binding agent and a catalyst were added into a reaction device, stirred, protected by introducing nitrogen, and gradually dripped at a low temperature with a certain amount of p-benzoyl chloride. After reacting for 1-8 hours, a suitable amount of phenol was added, further reacted for 1-8 hours, cooled to room temperature, and filtered by suction. The filtrate was pressure-distilled to evaporate the solvent to obtain a viscous product.

30 g of said product was dissolved in an organic solvent, and then 40 g of DCPD benzoxazine (which is LZ8260 (Huntsman)), 20 g of DCPD epoxy resin (which is HP-7200H (DIC), and has an equivalent of 275-280), 10 g of styrene/maleic anhydride (which is EF-30, Sartomer) and a suitable amount of imidazole and pyridine were added, homogeneously stirred and mixed to obtain a varnish.

E-glass fabric having a size of 300×300 cm and a smooth and flat surface was homogeneously covered with said varnish, baked in an oven having a temperature of 155°C for 7 min to obtain a bonding sheet.

5 sheets of bonding sheets above whose edges were removed were superimposed, attached up and down with copper foils having a thickness of 35µm, placed in a vacuum thermocompressor to press and obtain a copper clad laminate. A multistep (heating and increasing the pressure step by step) procedure was used to press, wherein the temperature was increased by 15 min from room temperature to 150°C and maintained for 30 min, then increased by 5min to 190°C and maintained for 2 h, and finally decreased by 30 min to room temperature; the pressure was increased by 1min from 0 to 0.6Mpa and maintained for 20min, and then increased by 1min to 1.0Mpa and maintained for 2.5 h. The basic performances are shown in Table 1.

### Example 3

A solvent, a phenoxycyclotriphosphazene containing hydroxyl groups (wherein those containing two hydroxyl groups are in a proportion of higher than 65%), an acid-binding agent and a catalyst were added into a reaction device, stirred, protected by introducing nitrogen, and gradually dripped at a low temperature with a certain amount of p-benzoyl chloride. After reacting for 1-8 hours, a suitable amount of phenol was added, further reacted for 1-8 hours, cooled to room temperature, and filtered by suction. The filtrate was pressure-distilled to evaporate the solvent to obtain a viscous product.

30 g of said product was dissolved in an organic solvent, and then 30 g of DCPD cyanate (which is LONZA-Primaset DT-4000), 20 g of 4,4'-diphenylmethane bismaleimide, 20 g of DCPD epoxy resin (which is HP-7200H (DIC), and has an equivalent of 275-280), and a suitable amount of aluminium acetylacetonate and pyridine were added, homogeneously stirred and mixed to obtain a varnish.

E-glass fabric having a size of 300 × 300 cm and a smooth and flat surface was homogeneously covered with said varnish, baked in an oven having a temperature of 155°C for 7 min to obtain a bonding sheet.

5 sheets of bonding sheets above whose edges were removed were superimposed, attached up and down with copper foils having a thickness of 35µm, placed in a vacuum thermocompressor to press and obtain a copper clad laminate. A multistep (heating and increasing the pressure step by step) procedure was used to press, wherein the temperature was increased by 15 min from room temperature to 150°C and maintained for 30 min, then increased by 5min to 210°C and maintained for 2 h, and finally decreased by 30 min to room temperature; the pressure was increased by 1min from 0 to 0.6Mpa and maintained for 20min, and then increased by 1min to 1.0Mpa and maintained for 2.5 h. The basic performances are shown in Table 1.

### Example 4

A solvent, a phenoxycyclotriphosphazene containing hydroxyl groups (wherein those containing two hydroxyl groups are in a proportion of higher than 65%), an acid-binding agent and a catalyst were added into a reaction device, stirred, protected by introducing nitrogen, and gradually dripped at a low temperature with a certain amount of p-benzoyl chloride. After reacting for 1-8 hours, a suitable amount of phenol was added, further reacted for 1-8 hours, cooled to room temperature, and filtered by suction. The filtrate was pressure-distilled to evaporate the solvent to obtain a viscous product.

30 g of said product was dissolved in an organic solvent, and then 50 g of reactive polyphenyl ether resin (which is MX9000, SABIC), 20 g of DCPD epoxy resin (which is HP-7200H (DIC), and has an equivalent of 275-280), and a suitable amount of 2,5-di(2-ethylhexanoylperoxy)-2,5-dimethylhexane and pyridine were added, homogeneously stirred and mixed to obtain a varnish.

E-glass fabric having a size of 300 × 300 cm and a smooth and flat surface was homogeneously covered with said varnish, baked in an oven having a temperature of 155°C for 7 min to obtain a bonding sheet.

5 sheets of bonding sheets above whose edges were removed were superimposed, attached up and down with copper foils having a thickness of 35µm, placed in a vacuum thermocompressor to press and obtain a copper clad laminate. A multistep (heating and increasing the pressure step by step) procedure was used to press, wherein the temperature was increased by 15 min from room temperature to 150°C and maintained for 30 min, then increased by 5min to 190°C and maintained for 2 h, and finally decreased by 30 min to room temperature; the pressure was increased by 1min from 0 to 0.6Mpa and maintained for 20min, and then increased by 1min to 1.0Mpa and maintained for 2.5 h. The basic performances are shown in Table 1.

### Example 5

Bisphenol A novolac epoxy resin (BNE200, Taiwan's Chang Chun Plastics Plant) was used to replace DCPD epoxy resin, and the others were the same as those in Example 1.

### Example 6

A solvent, a phenoxycyclotriphosphazene containing hydroxyl groups (wherein those containing two hydroxyl groups are in a proportion of higher than 65%), an acid-binding agent and a catalyst were added into a reaction device, stirred, protected by introducing nitrogen, and gradually dripped at a low temperature with a certain amount of p-benzoyl chloride. After reacting for 1-8 hours, a suitable amount of phenol was added, further reacted for 1-8 hours, cooled to room temperature, and filtered by suction. The filtrate was pressure-distilled to evaporate the solvent to obtain a viscous product.

10 g of said product was dissolved in an organic solvent, and then 15 g of cyanate (which is LONZA-Primaset BA-230s), 5 g of naphthol epoxy resin (which is HPC-9500 (DIC)), and a suitable amount of aluminium acetylacetonate and pyridine were added, homogeneously stirred and mixed to obtain a varnish.

E-glass fabric having a size of 300×300 cm and a smooth and flat surface was homogeneously covered with said varnish, baked in an oven having a temperature of 155°C for 7 min to obtain a bonding sheet.

2 sheets of bonding sheets above whose edges were removed were superimposed, attached up and down with copper foils having a thickness of 35µm, placed in a vacuum thermocompressor to press and obtain a copper clad laminate. A multistep (heating and increasing the pressure step by step) procedure was used to press, wherein the temperature was increased by 15 min from room temperature to 150°C and maintained for 30 min, then increased by 5min to 210°C and maintained for 2 h, and finally decreased by 30 min to room temperature; the pressure was increased by 1min from 0 to 0.6Mpa and maintained for 20min, and then increased by 1min to 1.0Mpa and maintained for 2.5 h. The basic performances are shown in Table 1.

### Example 7

A solvent, a phenoxycyclotriphosphazene containing hydroxyl groups (wherein those containing two hydroxyl groups are in a proportion of higher than 65%), an acid-binding agent and a catalyst were added into a reaction device, stirred, protected by introducing nitrogen, and gradually dripped at a low temperature with a certain amount of p-benzoyl chloride. After reacting for 1-8 hours, a suitable amount of phenol was added, further reacted for 1-8 hours, cooled to room temperature, and filtered by suction. The filtrate was pressure-distilled to evaporate the solvent to obtain a viscous product.

50 g of said product was dissolved in an organic solvent, and then 85 g of DCPD epoxy resin (which is HP-7200H (DIC), and has an equivalent of 275-280), and a suitable amount of imidazole and pyridine were added, homogeneously stirred and mixed to obtain a varnish.

E-glass fabric having a size of 300 × 300 cm and a smooth and flat surface was homogeneously covered with said varnish, baked in an oven having a temperature of 155°C for 7 min to obtain a bonding sheet.

1 sheet of bonding sheet above whose edge was removed was superimposed, attached up and down with copper foils having a thickness of 18µm, placed in a vacuum thermocompressor to press and obtain a copper clad laminate. A multistep (heating and increasing the pressure step by step) procedure was used to press, wherein the temperature was increased by 15 min from room temperature to 150°C and maintained for 30 min, then increased by 5min to 180°C and maintained for 2 h, and finally decreased by 30 min to room temperature; the pressure was increased by 1min from 0 to 0.6Mpa and maintained for 20min, and then increased by 1min to 1.0Mpa and maintained for 2.5 h. The basic performances are shown in Table 1.

### Comparison Example 1

Except that 30 g of phenoxycyclotriphosphazene in Example 3 was replaced with 30 g of phosphorous-containing phenolic aldehyde (which is Dow Chemical XZ92741), the others were unchanged.

### Comparison Example 2

Except that 30 g of phenoxycyclotriphosphazene in Example 4 was replaced with 30 g of phosphorous-containing phenolic aldehyde (which is Dow Chemical XZ92741), the others were unchanged.

### Comparison Example 3

Except that 30 g of phenoxycyclotriphosphazene in Example 1 was replaced with 30 g of active ester (which is HP8000 by DIC), the others were unchanged.

### Comparison Example 4

Except that 30 g of phenoxycyclotriphosphazene in Example 2 was replaced with 30 g ofphosphazo active ester having the following structural formula, 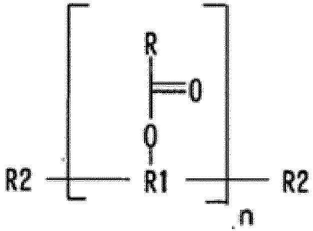 wherein R is phenyl; R1 is phosphazo skeleton; R2 is phenyl,
the others were unchanged.

The basic performances are shown in Table 1.

**Table 1 Property evaluation**

| | Exp.1 | Exp.2 | Exp.3 | Exp.4 | Exp.5 | Exp.6 | Exp.7 | Com. Exp.1 | Com. Exp.2 | Com. Exp.3 | Com. Exp.4 |
|---|---|---|---|---|---|---|---|---|---|---|---|
| Glass transition temperature (Tg,°C, DMA) | 170∼ 180 | 180∼ 195 | 195∼ 225 | 185∼ 215 | 195∼ 225 | 195∼ 230 | 160∼ 170 | 200∼ 230 | 190∼ 220 | 180∼190 | 190∼ 200 |
| Peeling strength (1/2OZ, N/mm) | >1.2 | >1.2 | >0.8 | >0.8 | >1.2 | >1.0 | >1.2 | >1.0 | >1.0 | >1.0 | >1.0 |
| Flame-retardancy (1.60mm) | V-1 | V-0 | V-0 | V-0 | V-1 | V-0 | V-0 | V-0 | V-0 | combusting | V-1 |
| Dip soldering resistance (delamination) | ○ | Δ | ○ | ○ | ○ | ○ | ○ | ○ | ○ | ○ | × |
| Hydroscopicity (%) | 0.07 | 0.06 | 0.08 | 0.07 | 0.010 | 0.006 | 0.008 | 0.12 | 0.12 | 0.06 | 0.15 |
| Dielectric constant (RC50, 1GHZ) | 4.0 | 4.2 | 3.8 | 3.6 | 4.3 | 3.9 | 4.1 | 3.7 | 3.5 | 3.9 | 4.0 |
| Dielectric loss (RC50, 1GHZ) | 0.010 | 0.009 | 0.005 | 0.003 | 0.018 | 0.004 | 0.011 | 0.005 | 0.003 | 0.009 | 0.010 |
| T-300/min | >60 | >60 | >120 | >120 | >60 | >120 | >60 | >120 | >120 | >120 | >30 |
| Punchability | ○ | Δ | ○ | ○ | ○ | ○ | ○ | Δ | ○ | ○ | ○ |

The aforesaid properties are tested by the following tests.

Flame-retardancy (flame retardancy): tested according to UL 94.

Dip soldering resistance: a sample (a substrate of 100 × 100mm) which was maintained for 2 h in a pressure cooking processing device at 121°C and 105 KPa was dipped for 20 seconds in a solder bath heated to 260°C, to visually observe (h1) whether there was delamination, and (h2) whether there were white spots or wrinkles. The symbols ○ represents unchanged; Δ represents that there are white spots.

Hydroscopicity: tested according to IPC-TM-650 2.6.2.1.

Dielectric dissipation factor: tested under 1GHz according to IPC-TM-650 2.5.5.5 and the resonance method of strips.

Punchability: a substrate having a thickness of 1.60 mm was placed on a die having a certain patterning for punching, to visually observe (h1) whether there were no white circles on the side of holes, (h2) whether there were white circles on the side of holes, and (h3) there were crackings on the side of holes, represented by the symbols ○, Δ and ×.

It can be seen according to the results above that phenoxycyclotriphosphazene active esters contain N and P atoms and have a better flame retardant effect as compared with HP8000 active esters by DIC, and has a low water absorption as compared with the active esters containing phosphates in Comparison Example 4. Phenoxycyclotriphosphazene active esters of the present invention can realize halogen-free flame retardancy without decreasing the dielectric properties (the halogen content falls within the scope of JPCA halogen-free standard), and have excellent heat resistance and better processibility.

The applicant declares that, the present invention detailedly discloses the process of the present invention by the aforesaid examples, but the present invention is not limited by the detailed process, i.e. it does not mean that the present invention cannot be fulfilled unless the aforesaid detailed process is used. Those skilled in the art shall know that, any amendment, equivalent change to the product materials of the present invention, addition of auxiliary ingredients, and selection of any specific modes all fall within the protection scope and disclosure scope of the present invention.

## Claims

1. A phenoxycyclotriphosphazene active ester, **characterized in** comprising at least 65 mol.% of a substance having the following structural formula 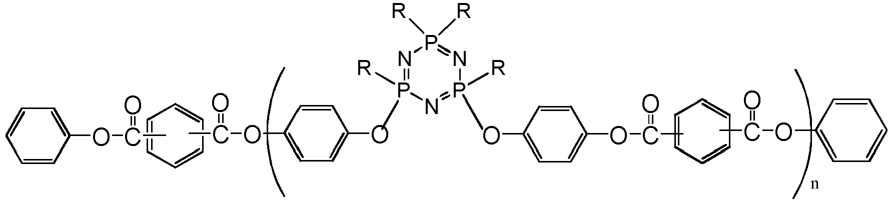 wherein, 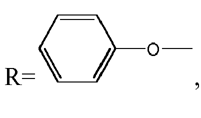 n represents any number between 0.25 and 3.

2. A halogen-free resin composition, **characterized in that** the halogen-free resin composition comprises 5-50 parts by weight of the phenoxycyclotriphosphazene active ester in claim 1, 15-85 parts by weight of a thermosetting resin, 1-35 parts by weight of a curing agent, 0-5 parts by weight of a curing accelerator and 0-100 parts by weight of an inorganic filler,
wherein the thermosetting resin is anyone selected from the group consisting of epoxy resin, benzoxazine resin, cyanate resin, bismaleimide resin, reactive polyphenyl ether resin or hydrocarbon resin, or a mixture of at least two selected therefrom.

3. The halogen-free resin composition as claimed in claim 2, **characterized in that** the thermosetting resin comprises dicyclopentadiene, biphenyl or naphthalene ring group.

4. The halogen-free resin composition as claimed in claim 2 or 3, **characterized in that** the epoxy resin is anyone selected from the group consisting of bisphenol A epoxy resin, bisphenol F epoxy resin, DCPD epoxy resin, triphenol epoxy resin, biphenyl epoxy resin or naphthol epoxy resin, or a mixture of at least two selected therefrom.

5. The halogen-free resin composition as claimed in claim 2 or 3, **characterized in that** the epoxy resin is phosphorous-containing epoxy resin containing 1.5-6.0 wt.% of phosphorous.

6. The halogen-free resin composition as claimed in claim 2 or 3, **characterized in that** the benzoxazine resin is anyone selected from the group consisting of bisphenol A benzoxazine resin, bisphenol F benzoxazine resin, DCPD benzoxazine resin or phenothalin benzoxazine resin, or a mixture of at least two selected therefrom.

7. The halogen-free resin composition as claimed in claim 2 or 3, **characterized in that** the cyanate resin is anyone selected from the group consisting of bisphenol A cyanate resin, DCPD cyanate resin or phenolic aldehyde cyanate resin, or a mixture of at least two selected therefrom.

8. The halogen-free resin composition as claimed in claim 2 or 3, **characterized in that** the bismaleimide resin comprises 4,4'-diphenylmethane bismaleimide or/and allyl-modified diphenylmethane bismaleimide.

9. The halogen-free resin composition as claimed in claim 2 or 3, **characterized in that** the reactive polyphenyl ether resin has a number average molecular weight of 1000-7000, and has reactive groups of hydroxyl groups or/and double bonds.

10. The halogen-free resin composition as claimed in claim 2 or 3, **characterized in that** the hydrocarbon resin is anyone selected from the group consisting of vinyl styrene butadiene resin having a number average molecular weight of less than 11,000, vinyl polybutadiene resin having polar groups or maleic anhydride-grafted butadiene and styrene resin, or a copolymer of at least two selected therefrom.

11. The halogen-free resin composition as claimed in claim 2, **characterized in that** the curing agent is anyone selected from the group consisting of dicyandiamide, aromatic amine, anhydride, phenolic compounds, triene isocyanurate or phosphorous-containing phenolic aldehyde, or a mixture of at least two selected therefrom.

12. The halogen-free resin composition as claimed in claim 2, **characterized in that** the curing accelerator is anyone selected from the group consisting of 2-methylimidazole, 2-ethyl-4-methylimidazole, 2-phenylimidazole, pyridine, DMP-30, hexamethylenetetramine, dicumyl peroxide, t-butyl peroxybenzoate, 2,5-di(2-ethylhexanoylperoxy)-2,5-dimethylhexane, acetylacetonate or zincate, or a mixture of at least two selected therefrom.

13. The halogen-free resin composition as claimed in claim 2, **characterized in that** the inorganic filler is anyone selected from the group consisting of aluminium hydroxide, magnesium hydroxide, zeolite, wollastonite, silica, magnesium oxide, calcium silicate, calcium carbonate, clay, talc or mica, or a mixture of at least two selected therefrom.

14. The halogen-free resin composition as claimed in claim 2, **characterized in that** the inorganic filler is in an amount of 25-100 parts by weight.

15. A prepreg, **characterized in that** the prepreg comprises a reinforcing material and the halogen-free resin composition claimed in anyone of claims 2-14 and attached thereon after impregnation and drying.

16. A laminate, **characterized in that** the laminate comprises at least one prepreg as claimed in claim 15.

17. A printed wiring board, **characterized in that** the printed wiring board comprises at least one prepreg as claimed in claim 15.
